# NEW EUROPEAN PATENT SPECIFICATION

(11) **EP 0 486 988 B2**
(45) Date of publication and mention of the opposition decision: **07.05.2003**
(45) Mention of the grant of the patent: 26.03.1997
(21) Application number: 91119633.5
(22) Date of filing: 18.11.1991
(51) Int. Cl.: H03J 1/00, H04N 7/087, H04N 5/76

(54) **Method for the selection and memorising of tuning information relating to radioelectric signals**
Methode zum Auswählen und Speichern von Einstellinformationen von radioelektrischen Signalen
Méthode pour la sélection et la mémorisation d'informations de syntonisation relatives des signaux radioélectriques

(30) Priority: 22.11.1990 IT 6791190
(43) Date of publication of application: 27.05.1992
(73) Proprietor: EDICO S.r.l., 00197 Roma (IT)
(72) Inventor: Dini, Roberto, I-10095 Rivoli (TO) (IT); Farina, Attilio, I-10127 Torino (IT)
(74) Representative: Eisenführ, Speiser & Partner

(56) References cited:
- EP-A- 0 118 104
- EP-A- 0 211 366
- EP-A- 0 253 110
- EP-A- 0 373 297
- DE-A- 3 909 334
- FR-A- 2 516 733
- US-A- 4 841 365
- US-A- 4 914 517

## Description

The present invention relates to a television signal receiver. In the prior art devices are known comprising means for receiving and tuning on radioelectric signals, memory means for memorising tuning information relative to said signals, and control means for identifying the broadcaster of said signals on the basis of a code present in the received signal.

For example a radio receiver is known from the U. S. patent application N° 3.882.400 that is able to search for all the the broadcasting stations and memorise them in a special memory, every time it finds them; the stations are thus memorised in a frequency order of emission.

It is known from EP-A2-0 125 453 a broadcast signal receiver having a tuner for an automatic search and a programme key board. The keys of said key board are fixedly allocated to a determined programme, by the use of filters which are tuned to specific signal identification codes.

It is known from DE-C2-3 145 407 a device for automatic programming of a station memory of a television receiver by use of a programme source catalogue transmitted with the television signal.

Furthermore, from the Italian patent application N° 1.107.168. a television signal receiver is known, endowed with a selection means for television signals, and a memory means, In which the user can memorise a certain number of television broadcasts received, in an order that he prefers.

In the case of the apparatus in the described U.S. patent application, the main drawback exists in the fact that the stations, being memorised in a frequency order, are not easily found by the user, who in the majority of the cases, is not able to remember the emission frequencies of the various stations, in the case of the device described in the Italian patent application, the drawback is that the user, in the initial phase, or any time that a broadcasting station is presented, must arrange for a search, identification and memorising of the emissions in a logic order, in such a way that it becomes easier to find them when necessary.

Both systems thus are not very satisfactory to the user.

The present invention takes these drawbacks into consideration and has the aim of indicating a system more effective than those known, for facilitating the selection of the memorised signals on behalf of the user. For achieving such aims the present invention has as its object a television signal receiver for the selection and memorising of tuning information relating to radioelectric signals, having the distinctive features described in claim 1.

Further aims and advantages of said invention will result in being clearer from the detailed description that follows and the annexed drawings supplied as an explicative and non-limiting example, wherein:
Figure 1 represents a block diagram of a part of a circuit of a television receiver according to the invention;
Figure 2 ablock diagram of a part of the logic control circuit of the apparatus in figure 1.

The present invention is also based on the recognition of the fact that the emissions radiate an identification signal, conforming to international standards, for example the technical document of the specifications 3217 or 3262 of the E.B.U., or the French standard DIDON ANTIOPE.

Such identification signals are already used in radio receivers so as to enable the user to recognise the broadcast being received; they are however also present in television signals (for example the marking DIDON ANTIOPE is present on line 16 of the television signal).

Furthermore identification signals are transmitted by television broadcasters that function according to the V.P.S. system (Video Programming System) for example in Germany under the form of a "label".

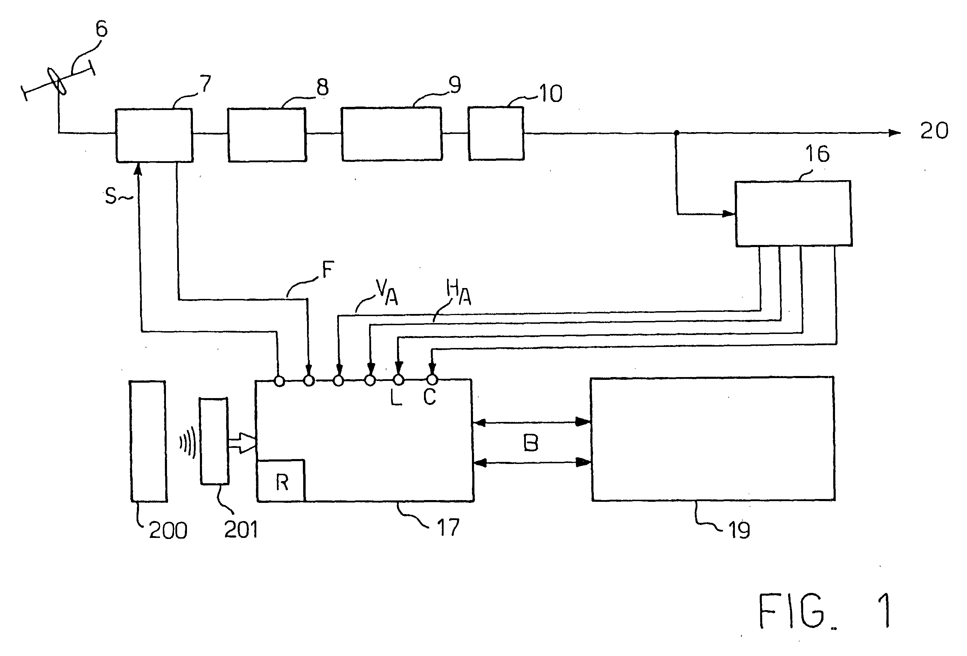

In figure 1 the block diagram represents a part of a circuit of a television receiver according to the invention, reference number 6 indicates the receiving antenna. reference number 7 indicates the tuner, of the type known with the denomination "frequency synthesis", that serves to tune a television signal.

Reference number 8 indicates an Intermediate frequency amplifier; number 9 the video detector and number 10 a pre-amplifier of the video signal.

Reference number 16 indicates a circuit block that generates, in a known way, the vertical and horizontal synchronism signals, starting from the special impulses contained in the pre-amplified video signal (20); block 16 also contains a known coincidence circuit, that checks whether the signal in arrival is in synchronism with the deflection signals, generating In a case a special coincidence signal (C); and a circuit that extracts from the video signal the identification of the broadcaster (L), based on the law in use; for example in the case of the standard DIDON ANTIOPE, the extractor can consist of a circuit that receives an appropriate window signal, active only in correspondence to line 16.

Signal 20 then continues towards the amplifier or the video final amplifiers, that apply it to the visualisation system, for example a picture tube.

Reference number 200 indicates a remote control unit, for example of the usual type with infrared rays; such transmitter contains a piurality of command keys (not represented in the figure), among them key M that begins the search operation and the memorising of the signal received; number 201 indicates the respective signal receiver, it is coupled to a control circuit indicated with the reference number 17.

Circuit 17 also receives the vertical and horizontal synchronism signals (VA, HA) and those coinciding (C), received from circuit 16, and a frequency signal (F), coming from the tuner 7; from circuit 17 then leaves a control signal of the tuner 7 (S).

Furthermore, circuit 17 also receivesfrom circuit 16, the signal that identifies the broadcaster, extracted from the video signal received. circuit 17 eventually decodes said signal.

Reference number 19 indicates a memory, preferably to be read or written, but in any case not of a volatile type; such memory is connected to circuit 17 by means of a bidirectional "bus" (B) and serves in memorising the tuning information relative to the plurality of signals received.

Control circuit 17 is a logic circuit, also containing a read only memory R, in which the operating instructions are memorised; it controls the functioning of the receiver; decodes the commands received bythe user through the remote control unit 200; tunes the television signals received by the antenna 6 and the tuner 7; memorises the information data for tuning into such signals in memory 19, and re-calls the data, if necessary to tune once again a preferred signal required by the user.

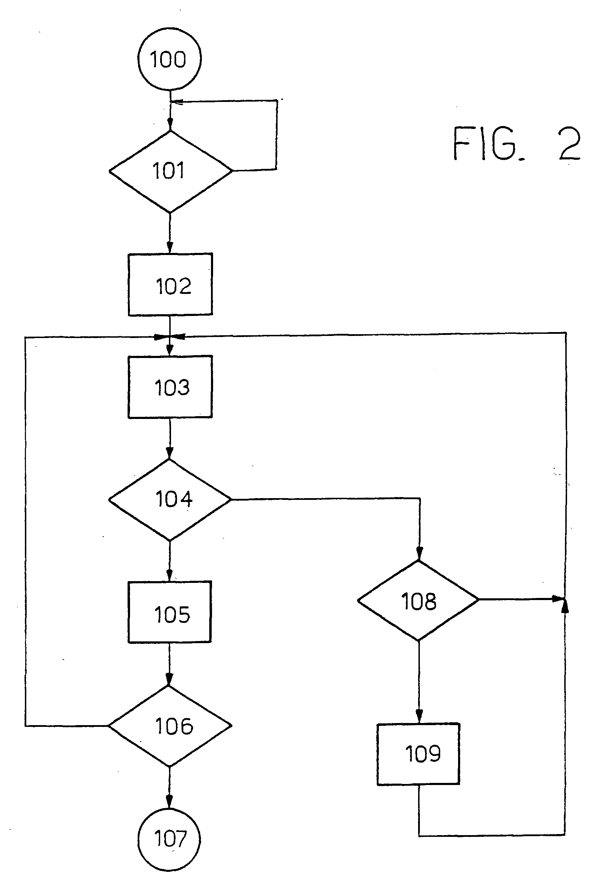

Figure 2 represents a block diagram of a part of the logic control circuit of the apparatus in figure 1; such a circuit, incorporated in the block indicated in figure 1 with the reference number 17, can be made with the system of logic programming i.e. using a microprocessor; systems of the that type are usually less expensive as television sets and video recorders already contain one or more microprocessors; the part indicated in figure 2 is that typical of the invention.

Block 100 is the block that begins the search operations and memorises the signals.

Block 101 is a check block; it checks whether the key. M on the remote control unit 100 has been pressed corresponding to the search order and regular memorising of the signals; in the affirmative control passes to block 102, in the negative case control passes back to the same block 101 (in all the check blocks the lower exit is the YES exit, whereas the lateral exit is the NO exit).

Block 102 starts the parameters for the broadcast search, putting the range index G=1 and the frequency divider index (that , as known represents the fundamental part of all the synthesis frequency systems) N=V1 i. e. to the initial value of the range 1. Control then passes to block 103.

Block 103 increases the division rate of frequency N to an established fixed quantity (N=N+I) and then passes the control to block 104.

The increase I can be equal to 1 if one desires to explore the range with a frequency increase equal to the resolution pitch of the system (in televisions the step is usually 50 or 62,5 KHz); alternatively the increase can be equal to more steps (I=2, I=3, etc.) if one accepts to explore the range with a greater step. A rapid system can be to explore the pitch range with channel steps, together with a system of AFC (in the case of broadcasts outside of raster).

Block 104 is a check block; it checks whether the end of range has been reached (comparing number N with the memorised range limit); in the affirmative control passes to block 105; in the negative case control passes to block 108.

Block 105 increase the range (G=G+1) and starts the corresponding number N (N=Vg); the control then passes to block 106.

Block 106 is a check block; it checks whether the end of exploration (G=4) has been reached; in the affirmative control passes to block 107; in the negative case control retums to block 103.

Block 107 is the final operations block that searches and memorises the signals received.

Block 108 is a check block; it checks whether a valid signal has been tuned; the validity of a signal is normally determined on the basis of the fact that the signal C of the comparator is positive; in the affirmative control passes to block 109; in the negative case the control returns to block 103.

Block 109 locates the broadcaster of the received signal by reading its identification code; it then reads in memory R in which cell of memory 19 it must memorise the tuning information relative to such broadcaster (numbers G and N, eventually also the identification code); it provides for such memorising (it puts the memory in WRITE, selects the memory cell read in R, memorises one piece of information after another, increasing the same memory each time, re-establishing the memory in READ);then the control returns to block 103.

The memorising is carried out in a logic order; for example in Italy the signal of RAI 1 will be memorised as program N°1; the signal of RAI 2 will be memorised as program N°2; the signal of RAI 3 will be memorised as program N° 3; the signal of Rete 4 will be memorised as program N°4; the signal of Canale 5 will be memorised. as program N°5; the signal of Telemontecarlo will be memorised as program N°6; the signal of Italia 7 will be memorised as program N°7; the signal of Swiss television will be memorised as program N°8; etc. The characteristics of the described device result clearer from the present description and annexed drawings.

The advantages of the device object of the present invention also become clearer from the description.

In particular they consist in the fact that the user only has to give the command M to find the received emissions automatically memorised in a logic and numeric order easy to find without any difficulties.

It is also clear that numerous variants can be supplied by the skilled man, to the visualising device of television images described as an example, without however departing from the novelty principles inherent in the present invention.

For example, it is clear that the tuner could be of the tension synthesis type instead of frequency synthesis as described, or any other type; it is foreseen the possibility for the user to modify the memorising order; in such cases a device is necessary that allows the user to indicate such an order to the control circuit 17 and a memory added to be read and written, for memorising said modified order.

Another advantageous variant, is that provided by block 109, besides memorising the information for the tuning of the broadcast, it also memorises the level of the signal received; and that, if it finds the same broadcast on a different frequency, it memorises the new coordinate, if and only if, the level of the signal is greater than that of the coordinate previously memorised. It is for this reason that block 17 also receives the information relative as to the level of the signal received; such information normally being available in block 9.

## Claims

1. Television signal receiver **characterised by** control means performing a method for selection and memorisation of tuning information relating to broadcast television channels in said television signal receiver, comprising the steps of:
- searching, with the receiving and tuning means of said receiver, for a broadcast television channel,
- when a channel has been found, identifying the broadcasting station on the basis of a code present in the channel signal,
- looking for the corresponding programme number of said broadcasting station in a table stored in a non-volatile memory of said receiver, said table containing a numbered list of broadcast channels in a pre-established order, whereby the list numbers correspond to programme numbers, - memorising the tuning information content of said identified broadcast channel signal in said non-volatile memory under the corresponding programme number in an established order in accordance with said pre-established order,
- whereby said pre-established order is a logic order and has been determined in the site of manufacturer of the receiver and memorised in said non-volatile memory, said logic order facilitating the selection of the memorized tuning information on behalf of the user,
- whereby said steps are executed automatically with a system of logic programming using a microprocessor,
- whereby said established order can be redetermined by the user.

2. Receiver according to claim 1, **characterised by** the fact that said code is the identification code of the known V.P.S., system.

3. Receiver according to claim 1, **characterised by** the fact that said code is the identification code provided by the DIDON ANTIOPE standard.

4. Receiver according to claim 1, **characterised by** the fact that said identification code is extracted from the received signal by means of a circuit comprising a signal generator of a window signal, active only in correspondence of said code.

5. Receiver according to claim 1, **characterised by** the fact that the memorising of said tuning information content also provides for the memorising of the level with which the relevant signals were received, and that, In the case in which the same source transmits on more than one frequency, only the signal which has the highest level is memorised.

6. Receiver according to claim 1, **characterised by** the fact that said tuning means include a coincidence circuit to determine the validity of the received signal.

## Patentansprüche

1. Fernsehsignalempfänger, **gekennzeichnet durch** Steuerungsmittel, die ein Verfahren zum Auswählen und Speichern von Einstellinformationen ausführen, die sich auf Fernsehsendekanäle in dem Fernsehsignalempfänger bezieht, welches folgende Schritte aufweist:
- Suchen nach einem Fernsehsendekanal mit den Empfänger- und Einstellmitteln des Empfängers,
- Identifizieren der Sendestation auf der Basis eines in dem Kanalsignal vorhandenen Kodes, wenn ein Kanal gefunden ist,
- Suchen nach der entsprechenden Programmnummer der Sendestation in einer Tabelle, die in einem Permanentspeicher des Empfängers gespeichert ist, wobei die Tabelle eine nummerierte Liste der Sendekanäle in einer vorher eingerichteten Reihenfolge enthält, wobei die Listennummern den Programmnummern entsprechen,
- Speichern des Einstellinformationsinhalts des identifizierten Sendekanalsignals in den Permanentspeicher unter der entsprechenden Programmnummer in einer eingerichteten Reihenfolge entsprechend der bereits eingerichteten Reihenfolge,
- wobei die bereits eingerichtete Reihenfolge eine logische Reihenfolge ist und auf Seiten des Herstellers des Empfängers bestimmt und in den Permanentspeicher gespeichert worden ist und die logische Reihenfolge die Auswahl der gespeicherten Abstimminformationen für den Benutzer erleichtert,
- wobei die Schritte automatisch ausgeführt werden mit einem logischen Programmiersystem, welches einen Mikroprozessor verwendet, und
- wobei die eingerichtete Reihenfolge von dem Benutzer neu bestimmt werden kann.

2. Empfänger nach Anspruch 1, **gekennzeichnet durch** die Tatsache, daß der Kode der Identifizierungskode des bekannten V.P.S.-Systems ist.

3. Empfänger nach Anspruch 1, **gekennzeichnet durch** die Tatsache, daß der Kode der Indentifizierungskode ist, der gemäß dem DIDON ANTIOPE-Standard vorgesehen ist.

4. Empfänger nach Anspruch 1, **gekennzeichnet durch** die Tatsache, daß der Indenitifizierungskode aus dem empfangenen Signal mittels einer Schaltung extrahiert wird, die einen ein Fenstersignal erzeugenden Signalgenerator aufweist, das nur im Ansprechen auf den Kode aktiv ist.

5. Empfänger nach Anspruch 1, **gekennzeichnet durch** die Tatsache, daß die Speicherung des Einstellinformationsinhalts auch die Speicherung des Pegels umfaßt, mit dem die relevanten Signale empfangen werden, und daß, wenn die gleiche Quelle auf mehr als einer Frequenz sendet, nur das Signal, das den höchsten Pegel aufweist, gespeichert wird.

6. Empfänger nach Anspruch 1, **gekennzeichnet durch** die Tatsache, daß die Einstellmittel eine Koinzidenzschaltung enthalten, um die Gültigkeit des empfangenen Signals festzustellen.

## Revendications

1. Récepteur de signal de télévision **caractérisé par** un moyen de commande pour réaliser un procédé de sélection et de mémorisation des informations de syntonisation relatives à des canaux d'émission de télévision dans un récepteur de signal de télévision, comprenant les étapes de :
- recherche, avec le moyen de réception et de syntonisation dudit récepteur, d'un canal d'émission de télévision,
- lorsqu'un canal a été trouvé, identification de la station sur la base d'un code présent dans le signal de canal,
- recherche du numéro de programme correspondant de ladite station d'émission dans une table stockée dans une mémoire non-volatile dudit récepteur, ladite table contenant une liste numérotée des canaux d'émission dans un ordre préétabli, de sorte que les numéros de liste correspondent aux numéros de programmes,
- mémorisation du contenu des informations de syntonisation dudit signal de canal d'émission identifié dans ladite mémoire non-volatile sous le numéro de programme correspondant dans un ordre établi selon ledit ordre pré-établi,
où ledit ordre préétabli est un ordre logique et a été déterminé dans le site du fabricant du récepteur et mémorisé dans ladite mémoire non-volatile, ledit ordre logique facilitant la sélection des informations de syntonisation mémorisées pour le comportement de l'utilisateur,
où lesdites étapes sont exécutées automatiquement avec un système de programmation logique en utilisant un microprocesseur,
où ledit ordre établi peut être redéterminé par l'utilisateur.

2. Récepteur selon la revendication 1, **caractérisé en ce que** ledit code est un code d'identification du système V.P.S. connu.

3. Récepteur selon la revendication 1, **caractérisé en ce que** ledit code est un code d'identification fourni par la norme ANTIOPE DIDON.

4. Récepteur selon la revendication 1, **caractérisé en ce que** ledit code d'identification est extrait du signal reçu au moyen d'un circuit comprenant un générateur de signal d'un signal de fenêtre, actif seulement en correspondance avec ledit code.

5. Récepteur selon la revendication 1, **caractérisé en ce que** la mémorisation dudit contenu des informations de syntonisation pourvoit aussi à la mémorisation du niveau avec lequel les signaux concernés étaient reçus, et **en ce que**, dans le cas où la même source émet sur plus qu'une fréquence, seulement le signal qui a le niveau le plus élevé est mémorisé.

6. Récepteur selon la revendication 1, **caractérisé en ce que** ledit moyen de syntonisation comprend un circuit de coïncidence pour déterminer la validité du signal reçu.
